# FASCICULE DE BREVET EUROPEEN

(11) **EP 0 592 343 B1**
(45) Date de publication et mention de la délivrance du brevet: **02.12.1998**
(21) Numéro de dépôt: 93470025.3
(22) Date de dépôt: 06.10.1993
(51) Int. Cl.: G03F 7/30

(54) **Procédé automatisé pour la confection de clichés souples à partir d'une plaque introduite face sensible tournée vers le haut et dispositif de mise en oeuvre du procédé**
Automatisches Verfahren zur Herstellung von flexiblen Druckplatten, wobei diese mit ihren sensibilisierten Oberflächen nach oben verarbeitet werden, und Vorrichtung zur Ausführung des Verfahrens
Automated process for the production of flexible printing plates, the plates being placed with the sensitive surface upwards, and apparatus therefor

(30) Priorité: 07.10.1992 FR 9212266
(43) Date de publication de la demande: 13.04.1994
(73) Titulaire: PHOTOMECA, 54340 Pompey (FR)
(72) Inventeur: Ferrante, Mario, F-54520 Laxou (FR)
(74) Mandataire: Poupon, Michel

(56) Documents cités:
- WO-A-92/22015
- DE-A- 3 503 974
- GB-A- 2 099 730
- US-A- 4 349 932
- PATENT ABSTRACTS OF JAPAN vol. 4, no. 177 (P-39)(659) 9 Décembre 1980 & JP-A-55 121 444 (HAJIME HONDA) 18 Septembre 1980

## Description

La présente invention concerne un procédé pour la réalisation de clichés souples, utilisables pour la réalisation d'imprimés en flexographie, typographie ou offset sec, elle concerne également un dispositif de mise en oeuvre du procédé.

Plus exactement, l'invention concerne un procédé pour traiter très rapidement des plaques photopolymères de tout format, afin de les transformer en clichés d'impression.

On sait déjà que l'on peut obtenir un cliché pour la flexographie ou la typographie en exposant une plaque de photopolymère sensible aux rayonnements ultraviolets, avec l'interposition d'un film négatif qui laisse exposées au rayonnement les zones qui doivent venir en relief sur le cliché terminé.

Le rayonnement durcit ces zones et on élimine ensuite la matière de la surface protégée en la brossant à l'aide de brosses planes ou rotatives ou par buses de pulvérisation ; un solvant ou de l'eau faisant office d'agent mouillant, on pousuit l'operation jusqu'à ce que les zones qui ont été exposées se trouvent suffisamment en relief.

Un premier objet de l'invention est d'automatiser complètement l'ensemble du procédé de gravure.

Par ailleurs, on trouve actuellement sur le marché une large gamme de plaques photopolymères de toutes épaisseurs et dans tous les formats (jusqu'à 50 x 80 pouces) et on fabrique déjà des machines semi-automatiques sur lesquelles le cliche photopolymère est fixé ou collé sur le plateau porte-cliche et une brosse plane à mouvement orbital baignant dans un bain de gravure, permet de confectionner des clichés.

On connaît également une machine décrite dans le document DE-A-35 04 974 où la gravure résulte de mouvements alternatifs d'ensembles de brosses planes. Les clichés sont en mouvement sur un tapis, défilent sous les ensembles de brosses et subissent des actions successives de brossage.

Un autre but de l'invention est donc de confectionner des clichés photopolymères de tous formats et épaisseurs, dans une machine simple, permettant d'introduire d'un côté un cliché déjà exposé et de récupérer celui-ci après gravure, presque sec, dans un minimum de temps.

Pour atteindre ces buts, plusieurs problèmes ont dû être résolus et notamment :
- diminution de la durée de l'opération de gravure,
- maintient automatique du cliché en position de gravure,
- mise du cliché en position de gravure automatiquement,
- gravure uniforme sur toute la surface,
- gravure de n'importe quelle épaisseur de plaques sans réglages spéciaux à exécuter,
- gravure de n'importe quelle dimension de plaques.

Ces problèmes sont résolus par la méthode selon la revendication 1 et le dispositif selon la revendication 5. Des réalisations préferentielles sont définies dans les revendications dépendantes.

Conformément à l'invention le nouveau procédé pour la confection de clichés à partir d'une plaque photopolymère préalablement exposée à un rayonnement ultra-violet afin de les transformer en clichés d'impression pour la flexographie, la typographie ou l'offset sec, se caractérisé en ce qu'il comporte au moins les étapes suivantes :
- Pénétration de la plaque face sensible tournée vers le haut sur un plan de gravure et sous un ensemble de brosses.
- Gravure de la plaque maintenue immobile par la pression résultante du poids des brosses et par la résultante d un mouvement alternatif des brosses planes et d'un mouvement de va et vient de l'ensemble des brosses dans une direction horizontale perpendiculaire à celle du mouvement alternatif desdites brosses.

Les brosses planes sont indépendantes les unes par rapport aux autres, la plaque est maintenue automatiquement en cours de gravure sur la plaque d'appui par la pression des brosses qui annule toutes poussées directionnelles et l'injection du liquide de gravure se fait au travers des brosses.

En outre, il comporte de préférence les étapes préalables suivantes :
- introduction rapide et accrochage de la plaque face sensible vers le haut,
- mise en place de la plaque sous les brosses et descente des brosses.

Et après gravure , les étapes suivantes :
- relèvement automatique des brosses,
- transfert de la plaque vers le rinçage et nettoyage automatique des deux faces,
- transfert dans la partie pré-séchage.

On comprendra mieux l'invention à l'aide de la description ci-après faite en référence aux figures annexées suivantes :
- Figure 1 à 8 : croquis montrant les étapes successives du procédé,
- Figure 9 : croquis montrant les brosses planes.

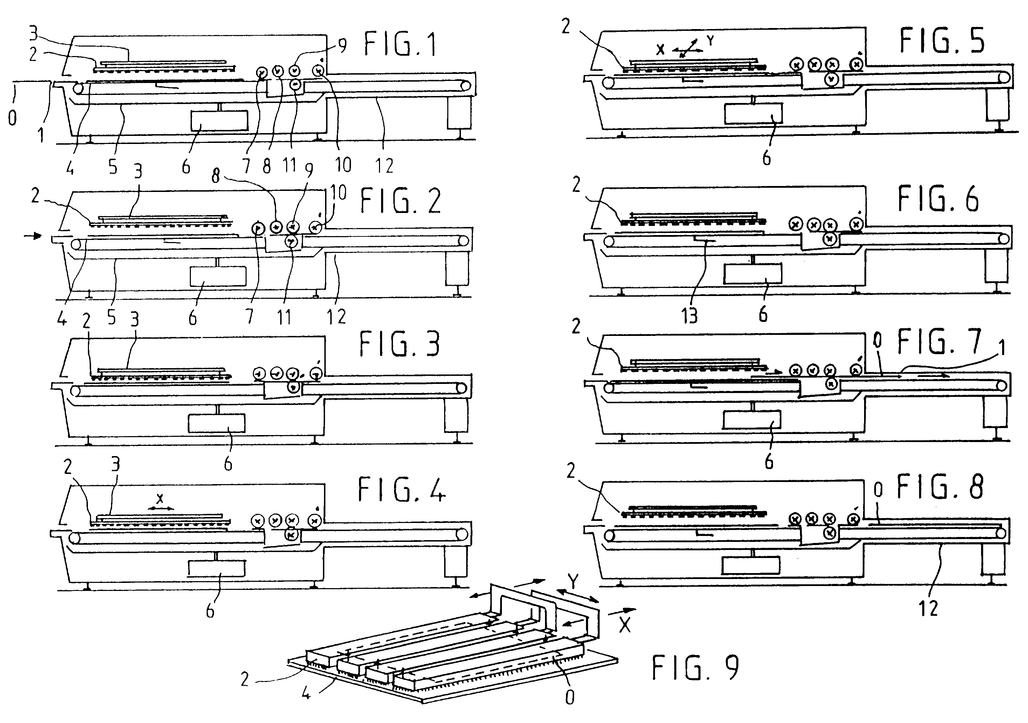

Le procédé selon l'invention comporte au moins les étapes suivantes :
- Etape de repos (voir figure 1)

Une plaque photopolymère (0) préalablement exposée aux rayons UV est accrochée sur une barre d'amenage (1) par l'opérateur,
- Introduction de la plaque (0) (voir figure 2)

L'opérateur introduit la barre à l'entrée de la machine sur la table d'entrée.

Il appuie sur le bouton Marche, en ayant au préalable réglé son temps de gravure sur la minuterie suivant l'épaisseur de la couche photopolymère à enlever ainsi que la quantité de liquide de gravure de régénération en fonction du creux nécessaire.

La plaque (0) vient à grande vitesse se positionner sous les brosses (2) et repose sur le plan de gravure (4) parfaitement plat lui-même supporté par une cuvre (5) de récupération de liquide reliée à un réservoir (6).
- Descente des brosses (2) (Figure 3)

Afin que la plaque (0) ne bouge pas pendant la gravure il faut que la plaque (0) soit positionnée toujours sous les brosses et ce pour n'importe quel format de plaque (0).

Pendant la descente des brosses (2) le liquide de gravure vient asperger la plaque (0) au travers des brosses et le mouvement du porte brosses (3) démarre de droite à gauche.

Juste avant de toucher la plaque (0) les brosses (2) se mettent en route (mouvement alternatif) pendant la descente.
- Gravure (figure 4)

Pendant la gravure, chaque brosse (2i vient frotter la surface de la plaque (0). Chaque brosse (2) porte un poids qui permet suivant sa surface de graver plus ou moins vite le photopolymère. Ce poids est déterminé afin d'avoir entre 15 à 18 grammes au cm2 entre la plaque (0) et la brosse (2).

Le liquide de gravure arrive au travers des corps de brosses (2).

La plaque (0) est immobilisée sur la table de gravure (4) pendant la gravure par le mouvement alternatif dans une direction X (figure 4) de chacune des brosses (2) entre elle.

Afin d'avoir une gravure uniforme de la surface de la plaque photopolymère (0) le support des brosses (3) entraine tout l'ensemble des brosses (2) dans un mouvement de direction Y (figure 5) de droite à gauche soit perpendiculaire à la direction X du mouvement alternatif des brosses (2).

La résultante : (figure 5)
. de la pression résultant du poids des brosses
. du mouvement alternatif des brosses planes (2)
. du mouvement de gauche à droite de l'ensemble des brosses (2)
permet de maintenir la plaque (0) en position fixe sans accrochage et d'avoir un système de gravure uniforme sur toute la surface selon deux directions orthogonales pour n'importe quelle dimension de plaque photopolymère et ceci en une seule fois.

L'ensemble des brosses venant recouvrir toute la surface de la plaque pendant la gravure, permet de graver simultanément toute la surface en une fois.

Le fait de graver ainsi en une seule fois la totalité de la surface permet d'avoir une gravure très rapide et la plaque (0) n'a pas le temps d'absorber le liquide de gravure et donc de gonfler.

Chaque brosse (2) est indépendante et libre l'une par rapport à l'autre c'est-à-dire "flottante"

Son propre poids permet de frotter la surface du photopolymère et d'enlever de la matière par le frottement des poils des brosses (force d'appui de 15 à 18 g/cm2).

Ce système permet de pouvoir graver n'importe quelle épaisseur de plaque photopolymère sans réglage préalable de hauteur des brosses (3). Pour graver il faudra seulement régler au préalable le temps de gravure.
- Fin de gravure (figure 6)

Le support brosse (3) fait remonter les brosses (2) en fin de gravure.

Afin de pouvoir tracter plus facilement la plaque (0) par la chaîne à tétons, on vient injecter par dessous du produit de gravure propre entre la plaque (0) et le support de plaque (4) par un moyen (13). La plaque (0) ayant tendance à se coller sur la plaque support (4) (surtout dans le cas de plaques de grandes dimensions).
- Rinçage et nettoyage (figure 7)

La plaque (0) est tractée par la barre (1) laquelle est accrochée à chaque extrémité à une chaîne à tétons.

Une première brosse rotation spiralée (7) vient enlever le produit de gravure saturé qui se trouve sur la plaque (0).

Une autre brosse (8) aspergée de produit neuf nettoie la surface de la plaque à graver (0).

La brosse (9) rotative vient essorer la surface de la plaque (0).

La brosse (11) rotative, baignant dans un bac de liquide propre, viendra rincer le dos de la plaque (0) automatiquement à son passage.

Il faut noter que les brosses (11 et 9) s'auto-nettoient mutuellement entre elles par frottement lorsqu'il n'y a pas de plaque (0) qui passe.

Une dernière brosse dense (10), mouillée par une rampe de liquide neuf vient essuyer la surface de la plaque (0) au passage (relief de la plaque imprimante).
- Pré-séchage, fin de cycle (figure 8)

En arrivant dans cette chambre de pré-séchage (12), la surface de la plaque (0) est humide, mais aucune goutte de produit ne subsiste sur la plaque (0). Pendant le pré-séchage la chambre est chauffée à 60° environ.

Lorsque la plaque photopolymère (0) arrive dans la section de pré-séchage (12) on peut réintroduire une autre plaque (0) selon l'étape de la figure 1.

Ce procédé offre de nombreux avantages, notamment :
- la machine dans l'ensemble est très simple et ne nécessite aucun réglage préalable précis.
- pas de réglage de hauteur des brosses suivant les différentes épaisseurs de plaques (0),
- les brosses sont indépendantes l'une par rapport à l'autre et donc flottantes, c'est-à-dire libres, appuyant sur la plaque à développer par leur propre poids (aucun réglage),
- gravure de la plaque en une seule fois sur toute la surface - Diminution temps de gravure,
- gravure de n'importe quel format,
- automatisme complet des étapes,
- absorption minimum de produit de gravure par la plaque ; donc pas de déformation des caractères,
- gravure très rapide selon X et Y pour avoir ainsi une parfaite uniformité de gravure.
- gravure selon X par plusieurs brosses en mouvement alternatif l'une par rapport à l'autre (course de 40 à 80 mm),
- gravure selon Y par déplacement de droite à gauche de l'ensemble des brosses (course entre 50 et 120 mm).

## Revendications

1. Procédé pour la confection de clichés à partir d'une plaque (0) photopolymère préalablement exposée à un rayonnement ultra-violet afin de les transformer en clichés d'impression pour la flexographie, la typographie ou l'offset sec, caractérisé n ce qu'il comporte au moins les étapes suivantes :
- pénétration de la plaque (0) face sensible tournée vers le haut sur un plan de gravure (4) et sous un ensemble de brosses (2),
- gravure de la plaque maintenue immobile par la pression résultante du poids des brosses et par la résultante d'un mouvement alternatif des brosses planes (2) et d'un mouvement de va et vient de l'ensemble des brosses (2) dans une direction horizontale perpendiculaire à celle du mouvement alternatif desdites brosses.

2. Procédé selon la revendication précédente, caractérisé en ce qu'il comporte les étapes préalables suivantes :
- introduction rapide et accrochage à la barre (1) de la plaque (0) face sensible tournée vers le haut,
- mise en position de toute la surface de la plaque sous les brosses (2).

3. Procédé selon l'une des revendications 1 à 2, caractérisé en ce que pendant la descente des brosses (2) le liquide de gravure vient asperger la plaque (0) au travers des brosses.

4. Procédé selon l'une quelconque des revendications précédentes, caractérisé en ce qu'il comporte après gravure les étapes automatiques suivantes :
- relèvement automatique des brosses (2 et 3),
- injection de produit de gravure sous la plaque pour permettre le glissement plus facile de la plaque,
- rinçage et nettoyage automatique de la plaque (surface) et du dos de la plaque pendant la sortie de gravure,
- transfert et contrôle de la plaque face gravée,
- pré-séchage.

5. Dispositif pour la mise en oeuvre du procédé selon l'une des revendications 1 à 4, caractérisé en ce qu'il comporte :
- une plaque d'appui (4) pour gravure parfaitement plane sur laquelle repose, lors de la gravure, la plaque (0) à graver, la plaque d'appui (4) étant supportée par une cuve (5) de gravure, et un ensemble de brosses planes (2) indépendantes l'une par rapport à l'autre et situées au-dessus de la plaque d'appui (4) portées par un support de brosse (3),
- le support de brosse (3) comportant d'une part des moyens mécaniques d'entraînement de tout l'ensemble des brosses (2) dans un mouvement horizontal (Y) de va et vient de l'ensemble des brosses selon une première direction, et des moyens mécaniques d'entraînement des brosses planes (2) dans un mouvement alternatif selon une deuxième direction (X) perpendiculaire à la première,
- des moyens pour appuyer l'ensemble des brosses (2) sur la plaque (0) à graver de manière à exercer une pression résultante du poids des brosses sur la plaque à graver (0) reposant sur la plaque d'appui (4).

6. Dispositif selon la revendication 5 caractérisé en ce qu'il comporte en outre :
- une barre d'amenage (1) permettant de positionner en grande vitesse la plaque à graver (0) complètement sous la surface des brosses (2).

7. Dispositif selon l'une des revendications 5 à 6 caractérisé en ce qu'il comporte en outre :
- une brosse rotative (8) pour premier rinçage,
- une brosse rotative (9) et une brosse rotative (11) baignant dans un bac de liquide propre disposé de façon à effectuer un nettoyage-rinçage de la plaque.
- une brosse rotative (12) mouillée par une rampe de liquide pour l'essuyage de la surface supérieure de la plaque.

## Patentansprüche

1. Verfahren zur Herstellung von Klischees ausgehend von einer zuvor einer ultravioletten Strahlung ausgesetzten fotopolymeren Platte (0), um sie in Druckklischees für die Flexographie, die Typographie oder den Trockenoffset umzuwandeln, **dadurch gekennzeichnet**, daß es zumindest die folgenden Schritte aufweist:
- Einfügen der Platte (0) mit einer nach oben gewandten empfindlichen Seite auf eine Gravierfläche (4) und unter eine Bürstenanordnung (2),
- Gravieren der in Folge des aus dem Gewicht der Bürsten hervorgehenden Druckes unbeweglich gehaltenen Platte durch eine wechselnde Bewegung der ebenen Bürsten (2) sowie einer Bewegung des Kommen und Gehens der Bürstenanordnung (2) in einer horizontalen, bezüglich der wechselnden Bewegung der besagten Bürsten rechtwinkligen Richtung.

2. Verfahren gemäß dem vorhergehenden Anspruch, dadurch gekennzeichnet, daß es die folgenden vorhergehende Schritte umfaßt:
- schnelles Einführen und Auflegen der Platte (0) auf den Balken (1) mit einer nach oben gewandten empfindlichen Seite,
- Positionieren der gesamten Oberfläche der Platte unter die Bürsten (2).

3. Verfahren nach einem der vorhergehenden Ansprüche 1 bis 2, dadurch gekennzeichnet, daß während des Herunterfahrens der Bürsten (2) die Gravierflüssigkeit die Platte (0) durch die Bürsten hindurch besprengt.

4. Verfahren nach irgendeinem der vorhergehenden Ansprüche, dadurch gekennzeichnet, daß es nach dem Gravieren die folgenden automatisierten Schritte umfaßt:
- selbsttätiges Hochheben der Bürsten (2 und 3),
- Einspritzen des Gravierprodukts unter die Platte, um ein leichteres Gleiten der Platte zu ermöglichen,
- selbsttätiges Spülen und Reinigen der Platte (Oberfläche) und der Rückseite der Platte während des Austretens der Platte,
- Überführen und Kontrolle der gravierten Seite der Platte,
- Vortrocknen.

5. Vorrichtung zur Durchführung des Verfahrens gemäß einem der Ansprüche 1 bis 4, dadurch gekennzeichnet, daß sie umfaßt:
- eine Stützplatte (4) zum vollkommen ebenen Gravieren, auf der während des Gravierens die zu gravierende Platte (0) liegt, wobei die Stützplatte (4) durch einen Gravierbehälter (5) gehalten ist, und eine Anordnung ebener, voneinander unabhängiger Bürsten (2), die oberhalb der Stützplatte (4) angeordnet und von einer Bürstenhalterung (3) getragen sind,
- die Bürstenhalterung (3), die zum einen mechanische Antriebsmittel der gesamten Bürstenanordnung (2) für eine horizontale Bewegung (y) des Kommen und Gehens der Bürstenanordnung in einer ersten Richtung und mechanische Antriebsmittel der ebenen Bürsten (2) in einer wechselnden Bewegung in einer zweiten, bezüglich der ersten rechtwinkligen Richtung aufweist,
- Mittel zum Andrücken der Bürstenanordnung (2) an die Gravierplatte (0) zum Ausüben eines Drucks, der aus dem Gewicht der Bürsten auf die zu gravierende Platte (0) hervorgeht, die auf der Stützplatte (4) abgelegt ist.

6. Vorrichtung nach Anspruch 5, dadurch gekennzeichnet, daß sie darüber hinaus aufweist:
- einen Zuführungsbalken (1), der ein schnelles, vollständiges Positionieren der gesamten zu gravierenden Platte (0) unterhalb der Oberfläche der Bürsten (2) erlaubt.

7. Vorrichtung nach einem der Ansprüche 5 bis 6, dadurch gekennzeichnet, daß sie weiterhin aufweist:
- eine kreisende Bürste (8) für einen ersten Spülgang,
- eine kreisende Bürste (9) und eine kreisende Bürste (11), die in ein Becken mit Flüssigkeit getaucht und derart passend angeordnet sind, daß sie ein Reinigen und Spülen der Platte bewirken,
- eine von einer Flüssigkeitsrampe angefeuchtete kreisende Bürste (12) zum Trocknen der oberen Schicht der Platte.

## Claims

1. Process for the production of blocks from a photopolymeric plate (0) previously exposed to ultra-violet radiation in order to transform such plates into printing blocks for flexography, typrography or dry offset printing, characterised in that it comprises at least the following steps:
- penetration of the plate (0), with its sensitive face being turned upwardly on an engraving plane (4) and under an assembly of brushes (2),
- engraving of the plate non-displaceably held by the resultant pressure of the weight of the brushes and by the resultant of an alternating movement of the planar brushes (2) and of a to-and-fro movement of the assembly of brushes (2) in a horizontal direction perpendicular to that of the alternating movement of said brushes.

2. Process according to the preceding claim, characterised in that it comprises the following preliminary steps:
- rapid introduction and attachment to the bar (1) of the plate (0) with its sensitive face turned upwardly.
- positioning of the entire surface of the plate under the brushes (2).

3. Process according to one of claims 1 to 2, characterised in that the engraving liquid is sprinkled on the plate (0) through the brushes during the descent of the brushes (2).

4. Process according to any one of the preceding claims, characterised in that it comprises the following automatic steps after engraving:
- automatic raising of the brushes (2 and 3),
- injection of engraving product under the plate in order to permit the plate to slide more easily,
- rinsing and automatic cleaning of the plate (surface) and of the back of the plate during removal from engraving,
- transfer and checking of the engraved plate face,
- pre-drying.

5. Apparatus for carrying out the process according to one of claims 1 to 4, characterised in that it comprises:
- a support plate (4) for perfectly planar engraving on which rests during the engraving, the plate (0) to be engraved, the support plate (4) being supported by an engraving tank (5), and an assembly of planar brushes (2), each one independent of the other, situated above the support plate (4) and carried by a brush support (3),
- the brush support (3) comprising, on the one hand, mechanical means for driving the whole assembly of brushes (2) in a horizontal to-and-fro movement (Y) of the assembly of brushes in a first direction, and mechanical means for driving the planar brushes (2) in an alternating movement in a second direction (X) perpendicular to the first direction,
- means for supporting the assembly of brushes (2) on the plate (0) to be engraved, so as to exert a pressure, resulting from the weight of the brushes, on the plate (0) to be engraved, which rests on the support plate (4).

6. Apparatus according to claim 5, characterised in that it also comprises:
- a positioning bar (1) permitting the plate (0) to be engraved to be positioned at great speed completely under the surface of the brushes (2).

7. Apparatus according to one of claims 5 to 6, characterised in that it also comprises:
- a rotatable brush (8) for the first rinsing,
- a rotatable brush (9) and a rotatable brush (11) immersed in a bath of clean liquid disposed so as to effect a cleaning and rinsing of the plate,
- a rotatable brush (12) moistened by a liquid flow for wiping the upper surface of the plate.
